# EUROPEAN PATENT APPLICATION

(11) **EP 4 826 907 A1**
(43) Date of publication of application: **21.10.2026**
(21) Application number: 24910497.7
(22) Date of filing: 27.11.2024
(51) Int. Cl.: H01P 5/10, H03H 7/42

(54) **BALUN, SEMICONDUCTOR DEVICE, AND COMMUNICATION APPARATUS**

(30) Priority: 29.12.2023 CN 202311864474
(71) Applicant: Huawei Technologies Co., Ltd., Shenzhen, Guangdong 518129 (CN)
(72) Inventor: ZHOU, Quan, Shenzhen, Guangdong 518129 (CN); FAN, Jinhan, Shenzhen, Guangdong 518129 (CN)
(74) Representative: Huawei European IPR
(86) International application number: PCT/CN2024/134952
(87) International publication number: WO 2025/139564

(57) **Abstract**

This application provides a balun, a semiconductor device, and a communication apparatus, applied to the field of chip technologies, to resolve a problem of poor suppression effect of high-order harmonics in an existing communication circuit. The balun includes a first inductor, a second inductor magnetically coupled to the first inductor, and two resonant circuits. A first end of the first inductor is coupled to a non-inverting input port of the balun, and a second end of the first inductor is coupled to an inverting input port of the balun. A first end of the second inductor is coupled to the inverting output port of the balun, and a second end of the second inductor is coupled to the non-inverting output port of the balun. One of the resonant circuits is separately coupled to the non-inverting input port, the inverting output port, the first end of the first inductor, and the first end of the second inductor. The other resonant circuit is separately coupled to the inverting input port, the non-inverting output port, the second end of the first inductor, and the second end of the second inductor. On this basis, high-frequency signals with opposite phases may cancel each other out to suppress high-order harmonics.

## Description

This application claims priority to Chinese Patent Application No. 202311864474.6, filed with the China National Intellectual Property Administration on December 29, 2023 and entitled "BALUN, SEMICONDUCTOR DEVICE, AND COMMUNICATION APPARATUS", which is incorporated herein by reference in its entirety.

### TECHNICAL FIELD

This application relates to the field of chip technologies, and in particular, to a balun, a semiconductor device, and a communication apparatus.

### BACKGROUND

In a communication process, high-order harmonics existing in a communication link greatly affects communication quality. To reduce impact of the high-order harmonics on the communication quality, a filter circuit needs to be added to both a transmit link and a receive link of a communication signal to suppress the high-order harmonics. In a current method for suppressing the high-order harmonics, a harmonic suppression circuit with a complex structure needs to be disposed between an amplifier and an off-chip antenna. However, such a method results in higher costs and a larger routing area. Therefore, in some solutions, the harmonic suppression circuit is disposed inside a chip to suppress the high-order harmonics by reducing impedance of a harmonic suppression frequency. However, passive devices such as on-chip inductors or capacitors have a low quality factor due to limitations of a chip manufacturing process, resulting in poor suppression effect of high-order harmonics. Therefore, it is urgent to provide a solution to resolve the foregoing problem.

### SUMMARY

This application provides a balun, a semiconductor device, and a communication apparatus to resolve a problem of poor suppression effect of high-order harmonics in an existing communication circuit.

To resolve the foregoing problem, embodiments of this application provide the following technical solutions.

According to a first aspect, a balun is provided, where the balun includes a differential non-inverting input port and inverting output port, a differential non-inverting output port and inverting input port, a first inductor, a second inductor, a first resonant circuit, and a second resonant circuit. A first end of the first inductor is coupled to the non-inverting input port, and a second end of the first inductor is coupled to the inverting input port. A first end of the second inductor is coupled to the inverting output port, and a second end of the second inductor is coupled to the non-inverting output port. A first end of the first resonant circuit is separately coupled to the non-inverting input port and the first end of the first inductor, and a second end of the first resonant circuit is separately coupled to the inverting output port and the first end of the second inductor. A first end of the second resonant circuit is separately coupled to the inverting input port and the second end of the first inductor, and a second end of the second resonant circuit is separately coupled to the non-inverting output port and the second end of the second inductor. The first inductor and the second inductor in the balun may couple a signal on an input side to an output side through magnetic coupling. To be specific, a signal (including an inverted low-frequency signal and an inverted high-frequency signal) input from the inverting input port may be coupled to the inverting output port via the first inductor and the second inductor, and a signal (including a non-inverted low-frequency signal and a non-inverted high-frequency signal) input from the non-inverting input port may be coupled to the inverting output port via the first inductor and the second inductor. The first resonant circuit and the second resonant circuit may resonate at a frequency, to be suppressed, of a high-frequency signal. The non-inverted high-frequency signal input from the non-inverting input port may be transmitted to the inverting output port via the first resonant circuit. The inverted high-frequency signal input from the inverting input port may be transmitted to the non-inverting output port via the second resonant circuit. Because the inverted high-frequency signal input from the inverting input port and the non-inverted high-frequency signal input from the non-inverting input port have a same frequency but opposite phases, the two signals may cancel each other out, so that a signal output from the inverting output port includes only the inverted low-frequency signal, and a signal output from the non-inverting output port includes only the non-inverted low-frequency signal. On this basis, in the balun provided in this application, an unwanted signal may be removed in a manner of signal cancellation, and a desired signal is retained. In addition, in the manner of signal cancellation, the first resonant circuit and the second resonant circuit in the balun only need to resonate at a frequency to be suppressed. Compared with a manner of reducing impedance of a harmonic suppression frequency, this method is not easily affected by a process of a chip, thereby improving the suppression effect of high-order harmonics.

In a possible implementation, the first resonant circuit includes a third inductor and a first capacitor that are connected in series between the first end of the first resonant circuit and the second end of the first resonant circuit. The second resonant circuit includes a fourth inductor and a second capacitor that are connected in series between the first end of the second resonant circuit and the second end of the second resonant circuit. In this way, an LC series resonant circuit formed by an inductor and a capacitor may enable the first resonant circuit and the second resonant circuit to resonate at a required frequency. In addition, because the LC series resonant circuit presents a high-impedance state for a normally transmitted low-frequency signal, the normally transmitted low-frequency signal may only be transmitted via the first inductor and the second inductor of the balun through magnetic coupling. In addition, because a high-frequency signal may be transmitted via the first inductor and the second inductor of the balun through magnetic coupling, there are two high-frequency signals with opposite phases at both the inverting output port and the non-inverting output port of the balun. After the two high-frequency signals cancel each other out, only the normally transmitted low-frequency signal is output from the inverting output port and the non-inverting output port of the balun.

In a possible implementation, the first capacitor and the second capacitor are adjustable capacitors. In this way, the first capacitor and the second capacitor may be adjusted synchronously to implement adjustment of a resonance frequency, thereby meeting more harmonic suppression requirements.

In a possible implementation, the third inductor and the fourth inductor are adjustable inductors. In this way, the third inductor and the fourth inductor may be adjusted synchronously to implement adjustment of a resonance frequency, thereby meeting more harmonic suppression requirements.

According to a second aspect, a balun is provided, where the balun includes a differential non-inverting input port and inverting output port, a differential non-inverting output port and inverting input port, a first inductor, a second inductor, a first capacitor, a second capacitor, and a third capacitor. A first end of the first inductor is coupled to the non-inverting input port, a second end of the first inductor is coupled to the inverting input port, and the first inductor is provided with a first tap and a second tap. A first end of the second inductor is coupled to the inverting output port, a second end of the second inductor is coupled to the non-inverting output port, a first end of the first capacitor is coupled to the first tap on the first inductor, and a second end of the first capacitor is separately coupled to the inverting output port and the first end of the second inductor. A first end of the second capacitor is coupled to the second tap on the first inductor, and a second end of the second capacitor is separately coupled to the non-inverting output port and the second end of the second inductor. A third capacitor is coupled between the first tap and the second tap and connected in parallel with a part that is of the first inductor and that is located between the first tap and the second tap. In this way, the first tap and the second tap may divide the first inductor into three parts, so that some coils of the first inductor in the balun are used as an inductor in an LC series resonant circuit, to reduce parts and components used, thereby reducing a routing area.

In a possible implementation, the first capacitor, the second capacitor, and the third capacitor are adjustable capacitors. In this way, the first capacitor, the second capacitor, and the third capacitor may be adjusted synchronously based on an actually required resonance frequency, to meet more harmonic suppression requirements.

According to a third aspect, a semiconductor device is provided. The semiconductor device includes an amplifier and the balun according to any one of the possible implementations of the first aspect or the second aspect. A non-inverting input of the amplifier is coupled to the non-inverting output port of the balun. An inverting input of the amplifier is coupled to the inverting output port of the balun. Alternatively, a non-inverting output of the amplifier is coupled to the non-inverting input port of the balun. An inverting output of the amplifier is coupled to the inverting input port of the balun.

According to a fourth aspect, a communication apparatus is provided. The communication identification includes the semiconductor device in the third aspect and a transceiver circuit coupled to the semiconductor device.

In a possible implementation, the communication apparatus further includes a baseband processor coupled to the transceiver circuit.

In a possible implementation, the communication apparatus further includes an antenna coupled to the semiconductor device.

For technical effect brought by the second aspect to the fourth aspect and the possible implementations, refer to descriptions of technical effect brought by the first aspect and the possible implementations. Details are not described herein again.

### BRIEF DESCRIPTION OF DRAWINGS

FIG. 1 is a diagram of a structure of a communication apparatus according to an embodiment of this application;
FIG. 2 is a diagram of a structure of a balun according to an embodiment of this application;
FIG. 3 is a diagram of a structure of another balun according to an embodiment of this application;
FIG. 4 is a diagram of a structure of a balun according to an embodiment of this application;
FIG. 5 is a diagram of a structure of another balun according to an embodiment of this application;
FIG. 6 is a diagram of a structure of yet another balun according to an embodiment of this application;
FIG. 7 is a diagram of a structure of a semiconductor device according to an embodiment of this application; and
FIG. 8 is a diagram of a structure of a communication apparatus according to an embodiment of this application.

### DESCRIPTION OF EMBODIMENTS

The following describes technical solutions in embodiments of this application with reference to accompanying drawings in embodiments of this application.

In this application, "at least one" means one or more, and "a plurality of" means two or more. The term "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects. "At least one of the following items (pieces)" or a similar expression thereof means any combination of these items, and includes a singular item (piece) or any combination of plural items (pieces). For example, at least one item (piece) of a, b, or c may indicate: a, b, c, "a and b", "a and c", "b and c", or "a, b, and c", where a, b, and c may be singular or plural. In addition, in embodiments of this application, terms such as "first" and "second" do not limit a quantity or a sequence.

It should be noted that, in this application, terms such as "example" or "for example" indicate giving an example, an illustration, or a description. Any embodiment or design scheme described as an "example" or "for example" in this application should not be explained as being more preferred or having more advantages than another embodiment or design scheme. To be precise, use of the terms such as "example" or "for example" is intended to present a related concept in a specific manner.

The following describes this application in detail with reference to the accompanying drawings and embodiments.

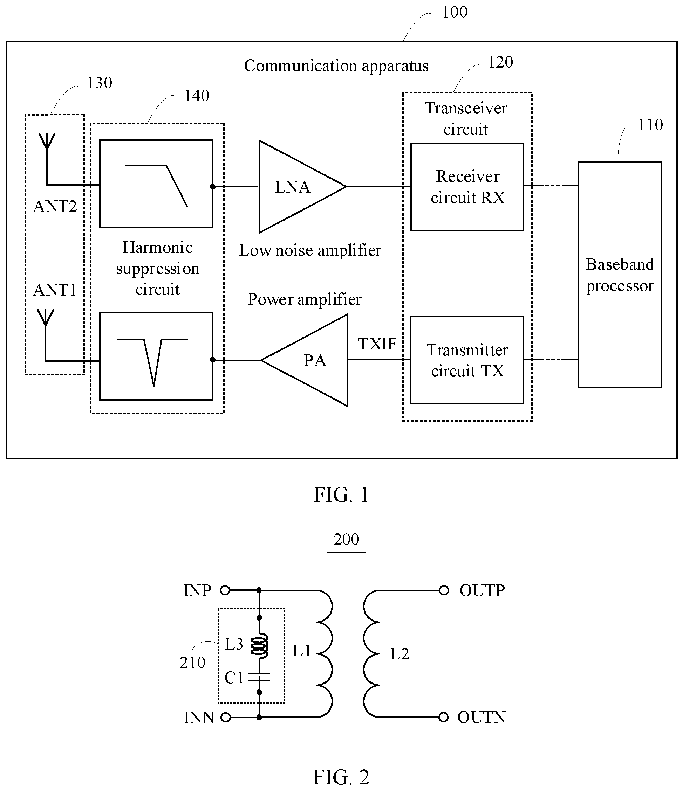

As shown in FIG. 1, with development of communications technologies, a baseband processor 110 (baseband processor), a transceiver circuit 120, a low noise amplifier (low noise amplifier, LNA), a power amplifier (power amplifier, PA), and an antenna 130 are disposed in many communication apparatuses 100. The transceiver circuit 120 includes a receiver circuit RX and a transmitter circuit TX. The antenna 130 includes a transmitting antenna ANT1 and a receiving antenna ANT2. The baseband processor 110 is coupled to the transmitting antenna ANT1 sequentially via the transmitter circuit TX and the power amplifier PA. In addition, the baseband processor 110 is coupled to the receiving antenna ANT2 sequentially via the receiver circuit RX and the low noise amplifier LNA. The communication apparatus 100 may be a chip, a module, or the like in an Internet of Things (internet of things, IOT) application scenario; or a device such as a mobile phone, a server, or a computer; or a radio frequency front-end (radio frequency front-end, RFFE) module in a device such as a mobile phone, a server, or a computer. In some application scenarios, for example, an Internet of Things application scenario, the power amplifier PA and the low noise amplifier LNA may be integrated into a same chip with the transceiver circuit 120. In some other scenarios, for example, in a scenario such as a mobile phone, a computer, and a server, the power amplifier PA and the low noise amplifier LNA may alternatively be disposed on a same semiconductor device as the transceiver circuit 120, the antenna 130, and the like, or disposed on a different semiconductor device. When the baseband processor 110 needs to send a signal to an external device, a transmitted intermediate frequency signal TXIF may be obtained after frequency synthesis is performed on the signal, output by the baseband processor 110, via the transmitter circuit TX. The transmitted intermediate frequency signal TXIF is amplified by the power amplifier PA and then transmitted from the transmitting antenna ANT1. When the receiving antenna ANT2 receives a signal sent by the external device, the signal may be first amplified by the low noise amplifier LNA. Then, the amplified signal is subjected to processing such as frequency mixing, filtering, and analog-to-digital conversion via the receiver circuit RX, and then transmitted to the baseband processor 110 for subsequent processing. However, in an actual transmission process, a normally transmitted original signal is easily affected by a high-frequency signal (that is, a high-order harmonic) with a frequency higher than a frequency of the original signal, thereby affecting communication quality. To suppress the high-order harmonic in the signal, still as shown in FIG. 1, a harmonic suppression circuit 140 may be disposed between the transceiver circuit 120 and the antenna 130. The high-order harmonic may be suppressed via the harmonic suppression circuit 140. However, use of the harmonic suppression circuit 140 in FIG. 1 requires many external components, resulting in a larger routing area and higher costs of a circuit board.

To resolve the foregoing problem, a balun may be disposed on an input side or an output side of an amplifier such as the power amplifier PA or the low noise amplifier LNA, and an impedance transformation circuit may be disposed on the balun to reduce impedance of a harmonic suppression frequency, thereby suppressing the high-order harmonic. For example, as shown in FIG. 2, a balun 200 includes a non-inverting input port INP, an inverting input port INN, a non-inverting output port OUTP, an inverting output port OUTN, a first inductor L1, and a second inductor L2. The first inductor L1 may serve as an inductor on an input side, the second inductor L2 may serve as an inductor on an output side, and the first inductor L1 and the second inductor L2 may transmit a signal on the input side to the output side through magnetic coupling. A first end of the first inductor L1 is coupled to the non-inverting input port INP. A second end of the first inductor L1 is coupled to the inverting input port INN. A first end of the second inductor L2 is coupled to the non-inverting output port OUTP. A second end of the second inductor L2 is coupled to the inverting output port OUTN. An LC series resonant circuit 210 formed by an inductor L3 and a capacitor C1 is further disposed between the non-inverting input port INP and the inverting input port INN of the balun 200. A first end of the LC series resonant circuit 210 is coupled to the non-inverting input port INP. A second end of the LC series resonant circuit 210 is coupled to the inverting input port INN. With the LC series resonant circuit 210, an unwanted high-order harmonic may be filtered out on an input side of the balun by reducing the impedance of the harmonic suppression frequency. However, in this solution, to achieve an adjustable frequency, the capacitor C1 is generally implemented as a switched capacitor array. This introduces a large series resistance. Therefore, the LC series resonant circuit has a large equivalent series resistance, poor frequency selectivity, and limited notch effect, making it difficult to meet system requirements and necessitating additional off-chip filtering. In addition, when the balun 200 is disposed in a chip, existing passive devices such as on-chip inductors or capacitors have a low quality factor due to impact of a chip manufacturing process, resulting in poor on-chip harmonic suppression effect.

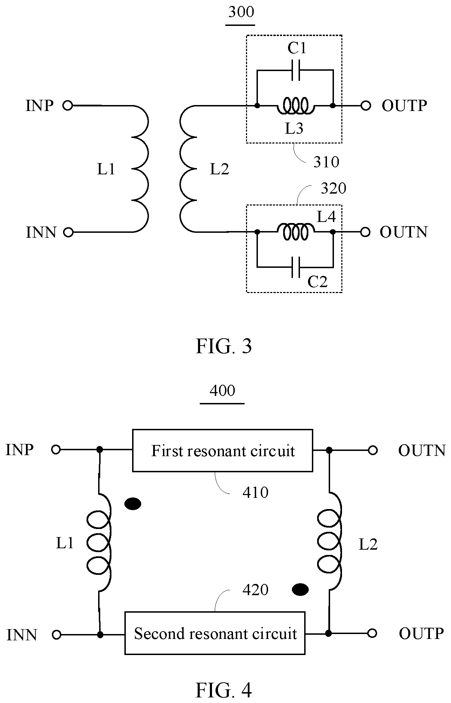

In another solution, as shown in FIG. 3, a balun 300 includes a non-inverting input port INP, an inverting input port INN, a non-inverting output port OUTP, an inverting output port OUTN, a first inductor L1, a second inductor L2, a first parallel resonant circuit 310, and a second parallel resonant circuit 320. The first inductor L1 may serve as an inductor on an input side, the second inductor L2 may serve as an inductor on an output side, and the first inductor L1 and the second inductor L2 may transmit a signal on the input side to the output side through magnetic coupling. The first parallel resonant circuit 310 is an LC parallel resonant circuit formed by an inductor L3 and a capacitor C1. The second parallel resonant circuit 320 is an LC parallel resonant circuit formed by an inductor L4 and a capacitor C2. A first end of the first inductor L1 is coupled to the non-inverting input port INP. A second end of the first inductor L1 is coupled to the inverting input port INN. A first end of the second inductor L2 is coupled to the non-inverting output port OUTP via the first parallel resonant circuit 310. A second end of the second inductor L2 is coupled to the inverting output port OUTN via the second parallel resonant circuit 320. With the first parallel resonant circuit 310 and the second parallel resonant circuit 320, the high-order harmonic may be filtered out on an output side of the balun by reducing the impedance of the harmonic suppression frequency. However, in this solution, to achieve an adjustable frequency, the capacitor C1 and the capacitor C2 are generally implemented as switched capacitor arrays. This introduces a large series resistance. Therefore, the LC parallel resonant circuit has a large equivalent series resistance, poor frequency selectivity, and limited notch effect, making it difficult to meet system requirements and necessitating additional off-chip filtering. In addition, when the balun 300 is disposed in a chip, existing passive devices such as on-chip inductors or capacitors have a low quality factor due to impact of a chip manufacturing process, resulting in poor on-chip harmonic suppression effect. In addition, the LC parallel resonant circuit is connected in series to the signal path, resulting in a large loss and degrading circuit performance.

To further resolve the foregoing problem, as shown in FIG. 4, an embodiment of this application provides a balun 400. The balun 400 includes a differential non-inverting input port INP and inverting output port OUTN, a differential non-inverting output port OUTP and inverting input port INN, a first inductor L1, a second inductor L2, a first resonant circuit 410, and a second resonant circuit 420. A first end of the first inductor L1 is coupled to the non-inverting input port INP. A second end of the first inductor L1 is coupled to the inverting input port INN. A first end of the second inductor L2 is coupled to the inverting output port OUTN. A second end of the second inductor L2 is coupled to the non-inverting output port OUTP. A first end of the first resonant circuit 410 is separately coupled to the non-inverting input port INP and the first end of the first inductor L1, and a second end of the first resonant circuit 410 is separately coupled to the inverting output port OUTN and the first end of the second inductor L2. A first end of the second resonant circuit 420 is separately coupled to the inverting input port INN and the second end of the first inductor L1, and a second end of the second resonant circuit 420 is separately coupled to the non-inverting output port OUTP and the second end of the second inductor L2. According to the balun 400, the first inductor L1 and the second inductor L2 may couple a signal on an input side to an output side through magnetic coupling. To be specific, a signal (including an inverted low-frequency signal and an inverted high-frequency signal) input from the inverting input port INN may be coupled to the inverting output port OUTN via the first inductor L1 and the second inductor L2, and a signal (including a non-inverted low-frequency signal and a non-inverted high-frequency signal) input from the non-inverting input port INP may be coupled to the non-inverting output port OUTP via the first inductor L1 and the second inductor L2. The first resonant circuit 410 and the second resonant circuit 420 may resonate at a frequency, to be suppressed, of a high-frequency signal. In this way, the non-inverted high-frequency signal input from the non-inverting input port INP of the balun 400 may be transmitted to the inverting output port OUTN via the first resonant circuit 410. The inverted high-frequency signal input from the inverting input port INN of the balun 400 may be transmitted to the non-inverting output port OUTP via the second resonant circuit 420. The signal input from the inverting input port INN includes the inverted high-frequency signal. The inverted high-frequency signal and the non-inverted high-frequency signal input from the non-inverting input port INP have a same frequency but opposite phases. Therefore, the two high-frequency signals may cancel each other out, so that a signal output from the inverting output port OUTN includes only a normal inverted low-frequency signal. Similarly, a signal output from the non-inverting output port OUTP includes only a normal non-inverted low-frequency signal. On this basis, an unwanted signal may be removed in a manner of signal cancellation, and a desired signal is retained. In addition, in the manner of signal cancellation, only the first resonant circuit 410 and the second resonant circuit 420 need to resonate at a frequency to be suppressed. Compared with a manner of reducing impedance of a harmonic suppression frequency, this method is not easily affected by a process of a chip, thereby improving the suppression effect of high-order harmonics.

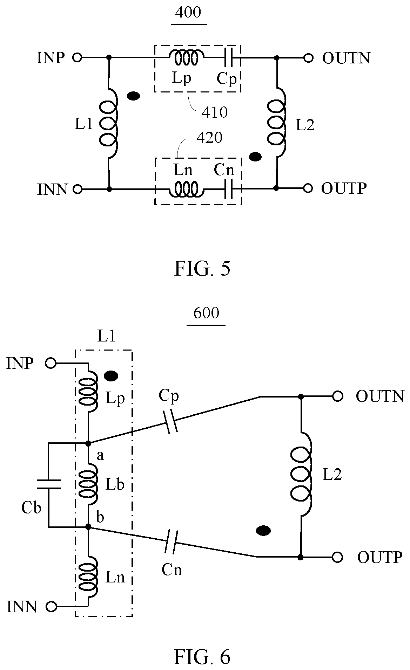

In an implementation solution, as shown in FIG. 5, the first resonant circuit 410 includes a first LC series resonant circuit formed by a third inductor Lp and a first capacitor Cp that are connected in series between the first end of the first resonant circuit 410 and the second end of the first resonant circuit 410. The second resonant circuit 420 includes a second LC series resonant circuit formed by a fourth inductor Ln and a second capacitor Cn that are connected in series between the first end of the second resonant circuit 420 and the second end of the second resonant circuit 420. The third inductor Lp and the first capacitor Cp resonate at a frequency to be suppressed. Similarly, the fourth inductor Ln and the second capacitor Cn resonate at a frequency to be suppressed. Because an LC series resonant circuit presents a high-impedance state for a low-frequency signal and a low-impedance state for a high-frequency signal, a signal at the non-inverting output port OUTP includes both a signal (including a non-inverted high-frequency signal and a non-inverted low-frequency signal) coupled by the non-inverting input port INP to the non-inverting output port OUTP via the first inductor L1 and the second inductor L2 of the balun and an inverted high-frequency signal transmitted by the inverting input port INN via the second LC resonant circuit formed by the fourth inductor Ln and the second capacitor Cn. The non-inverted high-frequency signal and the inverted high-frequency signal are high-frequency signals with a same frequency but opposite phases, and the two signals may cancel each other out at the non-inverting output port OUTP, thereby implementing a harmonic suppression function. Similarly, a signal at the inverting output port OUTN includes both a signal (including an inverted high-frequency signal and an inverted low-frequency signal) coupled by the inverting input port INN to the inverting output port OUTN via the first inductor L1 and the second inductor L2 of the balun and a non-inverted high-frequency signal transmitted by the non-inverting input port INP via the first LC resonant circuit formed by the third inductor Lp and the first capacitor Cp. Because the non-inverted high-frequency signal and the inverted high-frequency signal are high-frequency signals with a same frequency but opposite phases, the two signals may cancel each other out at the inverting output port OUTN, thereby implementing a harmonic suppression function.

For example, it is assumed that a frequency of a normally transmitted low-frequency signal is LO and that the frequency, to be suppressed, of the high-frequency signal is 3LO. In this case, the signals input from the inverting input port INN and the non-inverting input port INP both include a low-frequency signal with a frequency of LO and a high-frequency signal with a frequency of 3LO, and the signals input from the two input ports have only opposite phases. In this case, a non-inverted high-frequency signal with a frequency of 3LO may be transmitted to the inverting output port OUTN via the third inductor Lp and the first capacitor Cp. The signal input from the inverting input port INN (including an inverted low-frequency signal with a frequency of LO and an inverted high-frequency signal with a frequency of 3LO) is coupled to the inverting output port OUTN via the first inductor L1 and the second inductor L2. Because the two high-frequency signals have a same frequency but opposite phases, the two high-frequency signals may cancel each other out, so that the signal at the inverting output port OUTN includes only the inverted low-frequency signal with the frequency of LO. Similarly, an inverted high-frequency signal with a frequency of 3LO may be transmitted to the non-inverting output port OUTP via the fourth inductor Ln and the second capacitor Cn. The signal input from the non-inverting input port INP (including a non-inverted low-frequency signal with a frequency of LO and a non-inverted high-frequency signal with a frequency of 3LO) is coupled to the non-inverting output port OUTP via the first inductor L1 and the second inductor L2. Because the two high-frequency signals have a same frequency but opposite phases, the two high-frequency signals may cancel each other out, so that the signal at the non-inverting output port OUTP includes only the non-inverted low-frequency signal with the frequency of LO.

In an implementation solution, it is considered that a resonance frequency of an LC resonant circuit is mainly affected by an inductor and a capacitor. Therefore, the first capacitor Cp and the second capacitor Cn may be adjustable capacitors. For example, the first capacitor Cp and the second capacitor Cn may be implemented as a same switched capacitor array. The switched capacitor array includes a plurality of switches and capacitors. Capacitance values of the first capacitor Cp and the second capacitor Cn may be adjusted synchronously by controlling the switches to be in a same conducting state, thereby implementing adjustment of resonance frequencies of the first LC series resonant circuit and the second LC series resonant circuit.

In the foregoing implementation process, any switched capacitor array may be selected as the foregoing switched capacitor array. This is not specifically limited in this embodiment of this application.

Further, the third inductor Lp and the fourth inductor Ln may be adjustable inductors. Inductance values of the third inductor Lp and the fourth inductor Ln need to be kept the same in an adjustment process. Diversity of a resonance frequency of a resonant circuit may be enhanced by the adjustable inductor, thereby meeting harmonic suppression requirements in more application scenarios.

Further, based on the above, the balun 400 provided in this embodiment of this application may be further coupled to a controller (not shown in the figure). The controller may control the adjustable capacitor and the switched capacitor array, to adjust the inductor and/or the adjustable capacitor, thereby adjusting the resonance frequency of the resonant circuit to a frequency that meets a requirement. The foregoing controller may be a central processing unit (central processing unit, CPU), a general-purpose processor, a network processor (network processor, NP), a field programmable gate array (field programmable gate array, FPGA), an application-specific integrated circuit (application-specific integrated circuit, ASIC), a system on chip (system on chip, SoC), or any combination thereof. This is not specifically limited in this embodiment of this application.

In an implementation solution, as shown in FIG. 6, an embodiment of this application further provides a balun 600. The balun 600 includes a differential non-inverting input port INP and inverting output port OUTN, a differential non-inverting output port OUTP and inverting input port INN, a first inductor L1, a second inductor L2, a first capacitor Cp, a second capacitor Cn, and a third capacitor Cb. A first end of the first inductor L1 is coupled to the non-inverting input port INP, a second end of the first inductor L1 is coupled to the inverting input port INN, and the first inductor L1 is provided with a first tap a and a second tap b. A first end of the second inductor L2 is coupled to the inverting output port OUTN, and a second end of the second inductor L2 is coupled to the non-inverting output port OUTP. A first end of the first capacitor Cp is coupled to the first tap a on the first inductor, and a second end of the first capacitor Cp is separately coupled to the inverting output port OUTN and the first end of the second inductor L2. A first end of the second capacitor Cn is coupled to the second tap b on the first inductor, and a second end of the second capacitor Cn is separately coupled to the non-inverting output port OUTP and the second end of the second inductor L2. A third capacitor Cb is coupled between the first tap a and the second tap b and connected in parallel with a part that is of the first inductor L1 and that is located between the first tap a and the second tap b. The first tap a and the second tap b may be a connection point, or a connection line led out from the first inductor L1, to divide the first inductor L1 into three parts (for example, a first sub-inductor Lp, a second sub-inductor Lb, and a third sub-inductor Ln in FIG. 6). In this way, the first sub-inductor Lp and the first capacitor Cp may form a first LC series resonant circuit. The third sub-inductor Ln and the second capacitor Cn may form a second LC series resonant circuit. The second sub-inductor Lb and the third capacitor Cb may form an LC parallel resonant circuit. Because the LC parallel resonant circuit presents a high-impedance state for a high-frequency signal, a low-frequency signal of a first node a may be transmitted to a second node b via the LC parallel resonant circuit formed by the second sub-inductor Lb and the third capacitor Cb. A high-frequency signal of the first node a may not be transmitted to the second node b via an LC parallel resonant circuit formed by the second sub-inductor Lb and the third capacitor Cb. A signal input from the inverting input port INN (including an inverted high-frequency signal and an inverted low-frequency signal) may be normally coupled to the inverting output port OUTN via the first inductor L1 and the second inductor L2. Similarly, a signal input from the non-inverting input port INP (including a non-inverted high-frequency signal and a non-inverted low-frequency signal) may be normally coupled to the non-inverting output port OUTP via the first inductor L1 and the second inductor L2. In addition, because an LC series resonant circuit presents a high-impedance state for a low-frequency signal and a low-impedance state for a high-frequency signal, a signal at the non-inverting output port OUTP includes both a signal (including a non-inverted high-frequency signal and a non-inverted low-frequency signal) coupled by the non-inverting input port INP to the non-inverting output port OUTP via the first inductor L1 and the second inductor L2 and an inverted high-frequency signal transmitted by the inverting input port INN via the second LC resonant circuit formed by the third sub-inductor Ln and the second capacitor Cn. The non-inverted high-frequency signal and the inverted high-frequency signal are high-frequency signals with a same frequency but opposite phases, and the two signals may cancel each other out at the non-inverting output port OUTP, thereby implementing a harmonic suppression function. Similarly, a signal at the inverting output port OUTN includes both a signal (including an inverted high-frequency signal and an inverted low-frequency signal) coupled by the inverting input port INN to the inverting output port OUTN via the first inductor L1 and the second inductor L2 and a non-inverted high-frequency signal transmitted by the non-inverting input port INP via the first LC resonant circuit formed by the first sub-inductor Lp and the first capacitor Cp. Because the non-inverted high-frequency signal and the inverted high-frequency signal are high-frequency signals with a same frequency but opposite phases, the two signals may cancel each other out at the inverting output port OUTN, thereby implementing a harmonic suppression function.

In this way, a part of the first inductor L1 may serve as an inductor in a resonant circuit, thereby reducing a routing area and costs. Certainly, in the foregoing implementation process, the first inductor L1 may alternatively be an equivalent inductor formed by three serially connected inductors. This is not specifically limited in this embodiment of this application.

For example, it is assumed that a frequency of a normally transmitted low-frequency signal is LO and that a frequency, to be suppressed, of a high-frequency signal is 4LO. In this case, the signals input from the inverting input port INN and the non-inverting input port INP both include a low-frequency signal with a frequency of LO and a high-frequency signal with a frequency of 4LO, and the signals input from the two input ports have only opposite phases. In this case, a non-inverted high-frequency signal with a frequency of 4LO may be transmitted to the inverting output port OUTN via the first sub-inductor Lp and the first capacitor Cp. The signal input from the inverting input port INN (including an inverted low-frequency signal with a frequency of LO and an inverted high-frequency signal with a frequency of 4LO) is coupled to the inverting output port OUTN via the first inductor L1 and the second inductor L2. Because the two high-frequency signals have a same frequency but opposite phases, the two high-frequency signals may cancel each other out, so that the signal at the inverting output port OUTN includes only the inverted low-frequency signal with the frequency of LO. Similarly, an inverted high-frequency signal with a frequency of 4LO may be transmitted to the non-inverting output port OUTP via the third sub-inductor Ln and the second capacitor Cn. The signal input from the non-inverting input port INP (including a non-inverted low-frequency signal with a frequency of LO and a non-inverted high-frequency signal with a frequency of 4LO) is coupled to the non-inverting output port OUTP via the first inductor L1 and the second inductor L2. Because the two high-frequency signals have a same frequency but opposite phases, the two high-frequency signals may cancel each other out, so that the signal at the non-inverting output port OUTP includes only the non-inverted low-frequency signal with the frequency of LO.

In an implementation solution, the first capacitor Cp, the second capacitor Cn, and the third capacitor Cb are adjustable capacitors. For example, the first capacitor Cp, the second capacitor Cn, and the third capacitor Cb may be optionally implemented as a switched capacitor array, to meet harmonic suppression requirements for different frequencies. The switched capacitor array includes a plurality of switches and capacitors. Capacitance values of the first capacitor Cp, the second capacitor Cn, and the third capacitor Cb may be adjusted synchronously by controlling a conducting state of the switches, to adjust resonance frequencies of the first LC resonant circuit, the second LC resonant circuit, and the parallel LC circuit to better meet a tuning requirement in an actual application scenario.

In the foregoing implementation process, any switched capacitor array may be selected as the foregoing switched capacitor array. This is not specifically limited in this embodiment of this application.

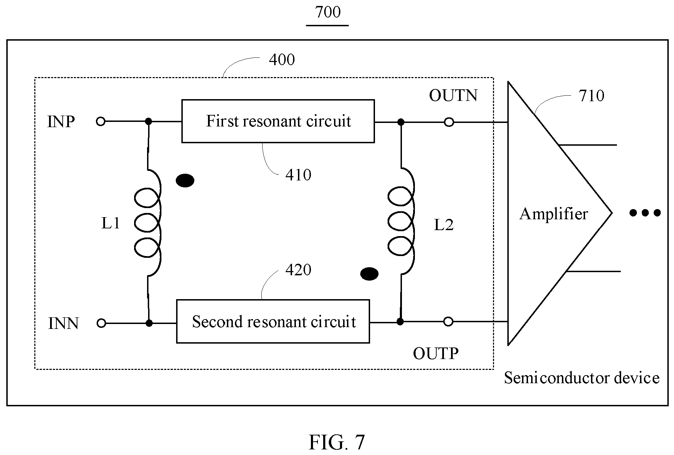

In an implementation solution, as shown in FIG. 7, an embodiment of this application further provides a semiconductor device 700. The semiconductor device 700 includes an amplifier 710 and the balun 400 in any one of the implementation solutions in FIG. 4 and FIG. 5. A non-inverting input of the amplifier 710 is coupled to the non-inverting output port OUTP of the balun 400. An inverting input of the amplifier 710 is coupled to the inverting output port OUTN of the balun 400. The amplifier 710 may be a low noise amplifier, a power amplifier, a preamplifier, or another type of differential amplifier. This is not specifically limited in this embodiment of this application.

In another implementation solution, a non-inverting output of the amplifier 710 may be coupled to the non-inverting input port INP of the balun 400. An inverting output of the amplifier 710 is coupled to the inverting input port INN of the balun 400. Certainly, the two solutions may be combined. To be specific, one balun 400 may be optionally disposed on an output side or an input side of the amplifier 710 separately. Details are not described again in this embodiment of this application.

In an example, the semiconductor device 700 may alternatively include a plurality of different types of amplifiers 710 (for example, a power amplifier PA and a low noise amplifier LNA) and a balun 400 coupled to each amplifier 710.

Certainly, the balun in FIG. 6 may be selected as the balun 400 in the semiconductor device 700. Details are not described again in this embodiment of this application.

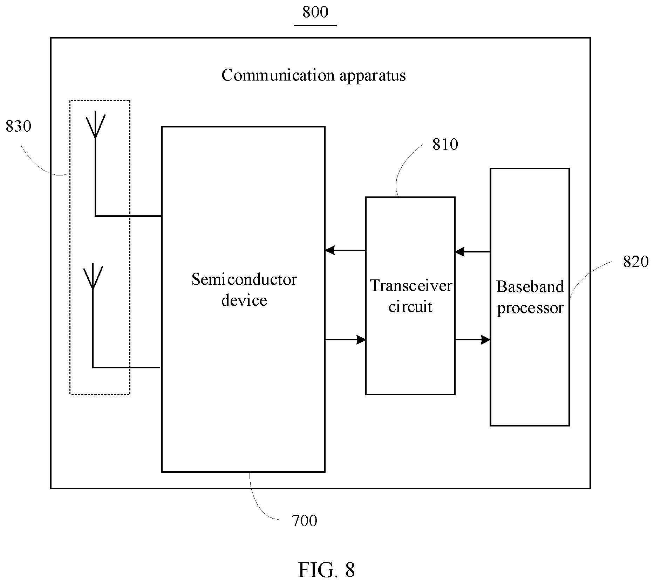

In an implementation solution, as shown in FIG. 8, an embodiment of this application further provides a communication apparatus 800. The communication apparatus 800 includes the semiconductor device 700 and a transceiver circuit 810 coupled to the semiconductor device 700. The communication apparatus 800 may be a device such as a mobile terminal device (for example, a mobile phone, a computer, a smart band, or a smart watch), a local area network device, or a server, or a radio frequency front-end module in a device such as a mobile terminal device (for example, a mobile phone, a computer, a smart band, or a smart watch), a local area network device, or a server, or an integrated chip in an Internet of Things device. This is not specifically limited in this embodiment of this application. The semiconductor device 700 and the transceiver circuit 810 may be integrated in a same chip, or may be disposed separately.

In an implementation solution, the communication apparatus 800 may further include a baseband processor 820. The baseband processor 820 may be a central processing unit (central processing unit, CPU), a general-purpose processor, a network processor (network processor, NP), a field programmable gate array (field programmable gate array, FPGA), an application-specific integrated circuit (application-specific integrated circuit, ASIC), a system on chip (system on chip, SoC), or any combination thereof. This is not specifically limited in this embodiment of this application. Further, the communication apparatus 800 may further include an antenna 830 coupled to the semiconductor device 700. The antenna 830 and the semiconductor device 700 may be disposed in a same chip or radio frequency front-end module, or disposed in different modules of the communication apparatus 800. This is not specifically limited in this embodiment of this application.

Further, in the foregoing implementation process, the semiconductor device or the communication apparatus in the foregoing example may further include another type of component. This is not specifically limited in this embodiment of this application.

A person of ordinary skill in the art may be aware that, in combination with the examples described in embodiments disclosed in this specification, circuit functions may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

In the several embodiments provided in this application, it should be understood that the disclosed circuit and apparatus may be implemented in other manners. For example, the described device embodiment is merely an example. For example, division into modules is merely logical function division and may be other division during actual implementation. For example, a plurality of modules or components may be combined or may be integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

In addition, the chip in embodiments of this application may be integrated into one device, or each of the modules may exist alone physically, or two or more modules are integrated into one device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A balun, comprising:
a differential non-inverting input port and inverting output port, and a differential non-inverting output port and inverting input port;
a first inductor, wherein a first end of the first inductor is coupled to the non-inverting input port, and a second end of the first inductor is coupled to the inverting input port;
a second inductor, wherein a first end of the second inductor is coupled to the inverting output port, and a second end of the second inductor is coupled to the non-inverting output port;
a first resonant circuit, wherein a first end of the first resonant circuit is separately coupled to the non-inverting input port and the first end of the first inductor, and a second end of the first resonant circuit is separately coupled to the inverting output port and the first end of the second inductor; and
a second resonant circuit, wherein a first end of the second resonant circuit is separately coupled to the inverting input port and the second end of the first inductor, and a second end of the second resonant circuit is separately coupled to the non-inverting output port and the second end of the second inductor.

2. The balun according to claim 1, wherein the first resonant circuit comprises a third inductor and a first capacitor that are connected in series between the first end of the first resonant circuit and the second end of the first resonant circuit, and the second resonant circuit comprises a fourth inductor and a second capacitor that are connected in series between the first end of the second resonant circuit and the second end of the second resonant circuit.

3. The balun according to claim 2, wherein the first capacitor and the second capacitor are adjustable capacitors.

4. The balun according to claim 2 or 3, wherein the third inductor and the fourth inductor are adjustable inductors.

5. A balun, comprising:
a differential non-inverting input port and inverting output port, and a differential non-inverting output port and inverting input port;
a first inductor, wherein a first end of the first inductor is coupled to the non-inverting input port, a second end of the first inductor is coupled to the inverting input port, and the first inductor is provided with a first tap and a second tap;
a second inductor, wherein a first end of the second inductor is coupled to the inverting output port, and a second end of the second inductor is coupled to the non-inverting output port;
a first capacitor, wherein a first end of the first capacitor is coupled to the first tap on the first inductor, and a second end of the first capacitor is separately coupled to the inverting output port and the first end of the second inductor;
a second capacitor, wherein a first end of the second capacitor is coupled to the second tap on the first inductor, and a second end of the second capacitor is separately coupled to the non-inverting output port and the second end of the second inductor; and
a third capacitor, coupled between the first tap and the second tap and connected in parallel with a part that is of the first inductor and that is located between the first tap and the second tap.

6. The balun according to claim 5, wherein the first capacitor, the second capacitor, and the third capacitor are adjustable capacitors.

7. A semiconductor device, comprising an amplifier and the balun according to any one of claims 1 to 4, or the balun according to claim 5 or 6, wherein a non-inverting input of the amplifier is coupled to the non-inverting output port of the balun, and an inverting input of the amplifier is coupled to the inverting output port of the balun; or a non-inverting output of the amplifier is coupled to the non-inverting input port of the balun, and an inverting output of the amplifier is coupled to the inverting input port of the balun.

8. A communication apparatus, comprising the semiconductor device according to claim 7 and a transceiver circuit coupled to the semiconductor device.

9. The communication apparatus according to claim 8, further comprising a baseband processor coupled to the transceiver circuit.

10. The communication apparatus according to claim 8 or 9, further comprising an antenna coupled to the semiconductor device.
